# FASCICULE DE BREVET EUROPEEN

(11) **EP 3 731 285 B1**
(45) Date de publication et mention de la délivrance du brevet: **18.01.2023**
(21) Numéro de dépôt: 20170995.3
(22) Date de dépôt: 23.04.2020
(51) Int. Cl.: H01L 33/38, H01L 33/60, H01L 33/58, H01L 27/15, H01L 33/40, H01L 33/50

(54) **PROCEDE DE REALISATION D'UN DISPOSITIF PHOTO-EMETTEUR ET/OU PHOTO-RECEPTEUR A GRILLE DE SEPARATION OPTIQUE METALLIQUE**
HERSTELLUNGSVERFAHREN EINER LICHT-EMITTIERENDEN ODER LICHT-EMPFANGENDEN VORRICHTUNG MIT OPTISCHEM TRENNGITTER AUS METALL
METHOD FOR PRODUCING A LIGHT-EMITTING AND/OR LIGHT-RECEIVING DEVICE WITH METAL OPTICAL SEPARATION GRID

(30) Priorité: 26.04.2019 FR 1904433
(43) Date de publication de la demande: 28.10.2020
(73) Titulaire: Commissariat à l'énergie atomique et aux énergies alternatives, 75015 Paris (FR)
(72) Inventeur: GASSE, Adrien, 38054 GRENOBLE CEDEX 09 (FR); DUPRE, Ludovic, 38054 GRENOBLE CEDEX 09 (FR); VOLPERT, Marion, 38054 GRENOBLE CEDEX 09 (FR)
(74) Mandataire: Brevalex

(56) Documents cités:
- US-A1- 2015 362 165
- US-A1- 2018 261 736
- US-A1- 2019 123 033

## Description

### DOMAINE TECHNIQUE ET ART ANTÉRIEUR

L'invention concerne le domaine des dispositifs à diodes photo-émettrices, telles que des diodes électroluminescentes (appelées DELs ou LEDs, ou encore micro-LEDs), et/ou à diodes photo-réceptrices telles que des photodiodes. L'invention s'applique notamment aux domaines suivants :
- dispositifs d'éclairage par LEDs, dispositifs électroniques comprenant des matrices de LEDs tels que des écrans, des projecteurs ou des murs d'images ;
- dispositifs électroniques ou microélectroniques photorécepteurs comportant des matrices de photodiodes, tels que des capteurs d'images ;
- dispositifs comportant à la fois des diodes photo-émettrices et des diodes photo-réceptrices, formant par exemple à la fois un capteur et un écran.

Le document US2019123033 A1 divulgue un dispositif photo-émetteur de l'art intérieur et son procédé de réalisation.

Dans un dispositif à diodes photo-émettrices et/ou photo-réceptrices, il est souvent avantageux d'augmenter la résolution du dispositif, c'est-à-dire augmenter le nombre de cellules actives, ou pixels, par unité de surface du dispositif. Cette augmentation de la résolution implique à la fois de diminuer la taille unitaire des pixels et d'améliorer la séparation optique des pixels entre eux pour diminuer notamment le « cross talk » ou la diaphonie, c'est-à-dire les interférences optiques se produisant entre pixels adjacents. Dans le cas de pixels comprenant des diodes photo-émettrices, l'augmentation de leur directivité participe également à l'augmentation de la résolution pouvant être atteinte par le dispositif.

En outre, cette augmentation de la résolution doit se faire en limitant les pertes liées à la sensibilité de réception et/ou de l'émissivité des dispositifs, ce qui implique que la réduction de la surface utile ou sensible des pixels, c'est-à-dire la surface de réception et/ou d'émission des pixels, soit accompagnée d'une réduction de la surface des zones mortes périphériques, c'est-à-dire de la surface n'émettant pas ou ne recevant pas de lumière, qui correspondent par exemple aux régions occupées par les électrodes des diodes et par les régions d'isolation localisées entre et autour des pixels. Cette réduction de la surface des zones mortes périphériques implique de minimiser leur largeur autour des pixels tout en maintenant ou en améliorant la séparation optique entre les pixels.

Dans les dispositifs actuels, l'obtention de bonnes performances nécessite de réaliser un élément de séparation optique des pixels, disposé au-dessus de la face émissive et/ou réceptrice des pixels. Un tel élément de séparation optique des pixels, appelé grille de collimation ou grille de séparation optique, permet d'éviter les interférences entre pixels voisins (cross talk) et peut également améliorer la directivité d'émission lumineuse. De plus, cette grille de séparation optique peut servir également à disposer sur les pixels des éléments de conversion en longueur d'onde d'un rayonnement destiné à être émis et/ou reçu par les pixels, permettant par exemple de changer la couleur émise ou de filtrer une lumière reçue. Dans le cas d'un dispositif photo-émetteur, un tel élément de conversion comporte par exemple du phosphore. Lorsque la hauteur de cet élément est importante, la grille de séparation optique sert donc à isoler optiquement les pixels les uns des autres.

Généralement, la grille de séparation optique est rapportée au-dessus des pixels après leur réalisation. Pour ne pas limiter la surface utile des pixels et obtenir de bonnes performances, les parois formant la grille de séparation optique sont réalisées aussi finement que possible, par exemple avec une largeur, ou épaisseur, inférieure à environ 5 µm pour des pixels ayant chacun une surface utile dont les côtés ont une dimension (largeur) égale à environ 40 µm, et avec une hauteur importante, par exemple supérieure à environ 10 µm. De telles dimensions conduisent à ce que la grille de séparation optique ait un rapport de forme (rapport hauteur/largeur) important, par exemple supérieur à 2. En outre, une bonne verticalité, une faible rugosité et une bonne réflectivité des parois permettent d'obtenir une grille de séparation optique qui ne perturbe pas la réflexion, la diffraction et la diffusion des signaux optiques reçus et/ou émis par les pixels.

Dans le cas d'un dispositif comprenant des diodes réalisant une photoémission et/ou une photo-réception depuis leur face avant (face opposée à celle se trouvant du côté du substrat sur lequel les diodes sont réalisées), une telle grille de séparation optique peut être réalisée pendant la fabrication des niveaux d'interconnexions, également appelés BEOL (« Back-End Of Line »), du dispositif. Un de ces niveaux d'interconnexions, formés du côté de la face avant des diodes, peut être dédié à la réalisation de la grille de séparation optique. Cette configuration permet d'obtenir un fort degré d'intégration, et donc un faible encombrement, ainsi qu'un bon alignement de la grille de séparation optique avec les pixels. Toutefois, cette configuration n'est pas applicable à un dispositif réalisant une émission et/ou une réception lumineuse depuis la face arrière des diodes car les niveaux d'interconnexions sont réalisés sur la face avant du dispositif. De plus, la hauteur de la grille de séparation optique ainsi obtenue est limitée par les techniques mises en oeuvre pour réaliser les niveaux d'interconnexions, cette hauteur étant généralement comprise entre environ 1 µm et 3 µm.

Dans le cas d'un dispositif réalisant une émission et/ou une réception lumineuse depuis sa face arrière, la grille de séparation optique est donc réalisée par un procédé spécifique mis en œuvre après la réalisation des niveaux d'interconnexions, le report du dispositif sur un support et le retrait du substrat à partir duquel le dispositif est réalisé. Le retrait du substrat libère la face arrière des diodes sur laquelle la grille de séparation optique est réalisée. Le problème principal à gérer est dans ce cas l'alignement de la grille de séparation optique avec les pixels.

De plus, lorsque la grille de collimation est réalisée par un dépôt de matériau dans des tranchées formées au préalable par lithographie, il est nécessaire de planariser le matériau déposé.

### EXPOSÉ DE L'INVENTION

Un but de la présente invention est de proposer un procédé de réalisation d'un dispositif photo-émetteur et/ou photo-récepteur à grille de séparation optique qui puisse s'appliquer à un dispositif réalisant une émission et/ou une réception lumineuse depuis sa face arrière, qui permet d'obtenir un bon alignement de la grille de séparation optique avec un ou plusieurs composants photo-émetteurs et/ou photorécepteurs du dispositif, et qui ne nécessite pas la mise en œuvre d'une planarisation d'un matériau déposé pour former la grille de séparation optique.

Pour cela, la présente invention propose un procédé de réalisation d'un dispositif photo-émetteur et/ou photo-récepteur à grille de séparation optique métallique, comprenant au moins :
- réalisation d'au moins un composant photo-émetteur et/ou photo-récepteur, dans lequel au moins une première électrode métallique du composant photo-émetteur et/ou photo-récepteur recouvre, ou est disposée contre, des flancs latéraux d'au moins un empilement semi-conducteur du composant photo-émetteur et/ou photo-récepteur et s'étend jusqu'à au moins une face émettrice et/ou réceptrice du composant photo-émetteur et/ou photo-récepteur ;
- traitement d'au moins une face de la première électrode métallique localisée au niveau de la face émettrice et/ou réceptrice, rendant mouillable ladite face de la première électrode métallique ;
- réalisation de la grille de séparation optique métallique sur au moins un support ;
- solidarisation de la grille de séparation optique métallique contre ladite face de la première électrode métallique par brasage ;
- retrait du support.

Ce procédé propose de reporter et solidariser une grille de séparation optique métallique par brasage en utilisant l'une des électrodes d'au moins un composant du dispositif pour définir les zones de contact sur lesquelles la grille de séparation optique est reportée et solidarisée, ces zones de contact étant préalablement rendues aptes au brasage, c'est-à-dire mouillables.

L'utilisation du brasage pour solidariser la grille de séparation optique permet d'aligner parfaitement la grille de séparation optique vis-à-vis du ou des composants photo-émetteurs et/ou photo-récepteurs du dispositif, grâce à l'effet d'auto-alignement se produisant lorsque le matériau de brasure utilisé est en fusion et que l'alignement se produit naturellement par capillarité entre la grille de séparation optique métallique et la face de la première électrode métallique.

Du fait que la grille de séparation optique est réalisée au préalable sur un support indépendamment du ou des composants photo-émetteurs et/ou photorécepteurs, aucune étape de planarisation de matériau n'est nécessaire, contrairement à une grille de séparation optique réalisée par dépôt de matériau dans des tranchées formées par lithographie, préalablement à la réalisation des composants.

En outre, ce procédé nécessite de mettre en œuvre peu d'étapes, avec peu de contraintes, et sans alignement complexe.

Ce procédé peut être mis en œuvre pour réaliser des matrices de LEDs couleur ou type RGB ou monochrome avec un très bon contraste, comme par exemple des phares matriciels LED pour automobile.

Un matériau ou une surface est qualifiée de mouillable lorsqu'une goutte de liquide, dans le cas présent de brasure liquide, se trouvant sur ce matériau ou sur cette surface forme un angle de contact inférieur à 90°.

La grille de séparation optique métallique est solidarisée contre ladite face de la première électrode métallique du côté opposé à celui où se trouve le support.

Le composant photo-émetteur et/ou photo-récepteur peut comporter au moins une diode photo-émettrice et/ou photo-réceptrice comprenant au moins :
- des première et deuxième portions de semi-conducteurs dopés faisant partie de l'empilement semi-conducteur et formant une jonction p-n, une première partie de la première portion de semi-conducteur dopé étant disposée entre une deuxième partie de la première portion de semi-conducteur dopé et la deuxième portion de semi-conducteur dopé ;
- des portions diélectriques recouvrant, ou disposées contre, des flancs latéraux de la première partie de la première portion de semi-conducteur dopé et des flancs latéraux de la deuxième portion de semi-conducteur dopé ;
- une deuxième électrode couplée électriquement à la deuxième portion de semi-conducteur dopé et telle que la deuxième portion de semi-conducteur dopé soit disposée entre la deuxième électrode et la première portion de semi-conducteur dopé ;
et dans lequel la première électrode métallique est disposée contre des flancs latéraux extérieurs des portions diélectriques et contre des flancs latéraux de la deuxième partie de la première portion de semi-conducteur dopé telle que la première électrode métallique soit couplée électriquement à la première portion de semi-conducteur dopé et isolée électriquement de la deuxième portion de semi-conducteur dopé.

Les flancs latéraux extérieurs des portions diélectriques correspondent aux flancs latéraux opposés à ceux disposés contre la première partie de la première portion et contre la deuxième portion.

Le procédé peut comporter en outre, entre la réalisation du composant photo-émetteur et/ou photo-récepteur et le traitement de la face de la première électrode métallique, ou après le retrait du support, un couplage électrique et mécanique du composant photo-émetteur et/ou photo-récepteur, du côté opposé à la face émettrice et/ou réceptrice, à au moins un circuit électronique de commande.

Le traitement de la face de la première électrode métallique peut comporter un dépôt d'au moins un matériau mouillable sur la face de la première électrode métallique, ou, lorsque la première électrode métallique comporte au moins un premier matériau métallique mouillable recouvert par au moins un deuxième matériau non mouillable, une gravure du deuxième matériau non mouillable présent sur la face de la première électrode métallique. Cette gravure du deuxième matériau non mouillable rend accessible le premier matériau métallique mouillable qui forme alors la face de la première électrode métallique sur laquelle la grille de séparation optique métallique est solidarisée par brasage.

Le procédé peut comporter en outre, entre la réalisation de la grille de séparation optique métallique et la solidarisation de la grille de séparation optique métallique, le dépôt d'au moins un matériau de brasure sur la grille de séparation optique métallique. Ce matériau de brasure correspond à celui utilisé pour le brasage de la grille de séparation optique métallique sur la face de la première électrode métallique. En variante, le matériau de brasure peut être déposé non pas sur la grille de séparation optique mais sur la première électrode. Selon une autre variante, il est possible de déposer un premier matériau de brasure sur la grille de séparation optique et un deuxième matériau de brasure sur la première électrode.

La grille de séparation optique métallique peut être réalisée sur le support avec au moins une couche sacrificielle disposée entre la grille de séparation optique métallique et le support, et le retrait du support peut être réalisé en supprimant la couche sacrificielle.

Dans ce cas, le procédé peut être tel que :
- le matériau de la couche sacrificielle soit apte à être gravé sélectivement vis-à-vis du matériau de la grille de séparation optique métallique ;
- le procédé comporte en outre, entre la réalisation de la grille de séparation optique métallique et la solidarisation de la grille de séparation optique métallique, une gravure partielle de la couche sacrificielle telle que des portions restantes de la couche sacrificielle soient localisées entre la grille de séparation optique métallique et le support ;
- le retrait du support est réalisé en supprimant les portions restantes de la couche sacrificielle.

En variante, le procédé peut être tel que :
- la couche sacrificielle comporte au moins un matériau apte à être dissous dans un solvant, et le retrait du support comporte au moins une mise en contact de la couche sacrificielle avec le solvant engendrant une dissolution du matériau de la couche sacrificielle, ou
- la couche sacrificielle comporte au moins du polyimide, et le retrait du support comporte au moins une mise en contact de la couche sacrificielle avec un plasma engendrant une gravure du polyimide.

Selon une autre variante, le procédé peut être tel que :
- la grille de séparation optique métallique est réalisée sur le support avec au moins une couche adhésive temporaire disposée entre la grille de séparation optique métallique et le support ;
- la couche adhésive temporaire comporte au moins un matériau dont les propriétés adhésives sont aptes à se dégrader à partir d'une température donnée à laquelle est exposé ledit matériau, et la solidarisation de la grille de séparation optique métallique est mise en œuvre à une température supérieure ou égale à ladite température donnée.

Selon une autre variante, le procédé peut être tel que :
- la grille de séparation optique métallique est réalisée sur le support avec au moins une couche adhésive temporaire disposée entre la grille de séparation optique métallique et le support ;
- la couche adhésive temporaire comporte au moins un matériau dont les propriétés adhésives sont aptes à se dégrader lorsque ledit matériau est exposé à un rayonnement électromagnétique, par exemple UV ou infrarouge, et le retrait du support comporte au moins une exposition de la couche adhésive temporaire au rayonnement électromagnétique à travers le support.

Selon une autre variante, le procédé peut être tel que :
- la grille de séparation optique métallique est réalisée sur le support avec au moins une couche d'oxyde et au moins une couche de platine disposées entre la grille de séparation optique métallique et le support ;
- le retrait du support comporte au moins une séparation mécanique à l'interface entre la couche d'oxyde et la couche de platine.

La réalisation de la grille de séparation optique métallique peut comporter en outre la réalisation, sur le support, d'au moins un élément de conversion en longueur d'onde d'un rayonnement destiné à être émis et/ou reçu par le composant photo-émetteur et/ou photo-récepteur, disposé entre des portions de la grille de séparation optique métallique tel qu'après la solidarisation de la grille de séparation optique métallique, l'élément de conversion en longueur d'onde soit disposé en regard de l'empilement semi-conducteur du composant photo-émetteur et/ou photo-récepteur.

L'élément de conversion en longueur d'onde peut comporter du phosphore.

Le procédé peut être tel que :
- plusieurs composants photo-émetteurs et/ou photo-récepteurs sont réalisés et forment une matrice de pixels du dispositif photo-émetteur et/ou photo-récepteur ;
- la première électrode métallique est disposée autour de chacun des composants photo-émetteurs et/ou photo-récepteurs et est commune aux composants photo-émetteurs et/ou photo-récepteurs.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 21 représentent les étapes d'un procédé de réalisation d'un dispositif photo-émetteur et/ou photo-récepteur à grille de séparation optique métallique, objet de la présente invention, selon un premier mode de réalisation ;
- les figures 22 et 23 représentent des étapes d'un procédé de réalisation d'un dispositif photo-émetteur et/ou photo-récepteur à grille de séparation optique métallique, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

Un procédé selon la présente invention est défini dans les revendications annexées.

### EXPOSÉ DÉTAILLÉ DE MODES DE RÉALISATION PARTICULIERS

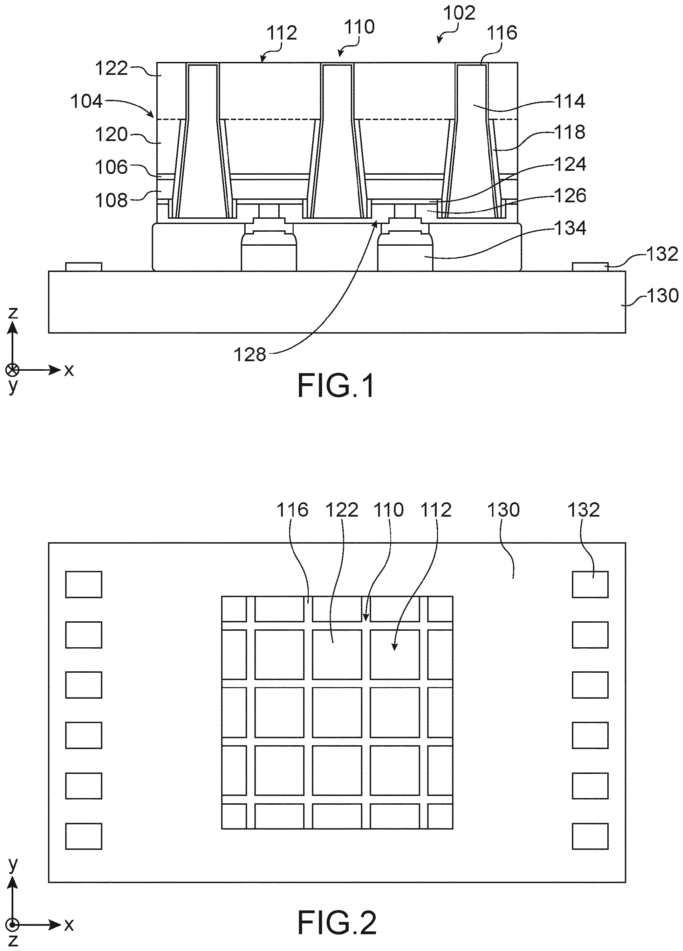

Les figures 1 à 21 décrites ci-dessous représentent les étapes d'un procédé de réalisation d'un dispositif photo-émetteur et/ou photo-récepteur 100 selon un premier mode de réalisation.

Dans une première étape, au moins un composant photo-émetteur et/ou photo-récepteur 102 du dispositif 100 est réalisé. Dans le premier mode de réalisation décrit ici, plusieurs composants photo-émetteurs et/ou photo-récepteurs 102 sont réalisés et agencés les uns à côté des autres en formant une matrice.

Dans l'exemple de réalisation particulier représenté sur les figures 1 à 21, le dispositif 100 réalisé correspond à un dispositif émissif et les composants 102 correspondent à des LEDs agencées en matrice. En variante, le dispositif 100 peut correspondre à un dispositif photo-récepteur dans lequel les composants 102 correspondent par exemple à des photodiodes. Selon une autre variante, le dispositif 100 peut être à la fois photo-émetteur et photo-récepteur et comporter une matrice comprenant à la fois des composants photo-émetteurs 102 tels que des LEDs et des composants photo-récepteurs 102 tels que des photodiodes.

La figure 1 représente une vue en coupe de plusieurs composants 102, et la figure 2 représente une vue de dessus de ces composants 102.

Chaque composant 102 comporte une première portion 104 de semi-conducteur dopé selon un premier type de conductivité, par exemple de type n. L'épaisseur de la première portion 104 correspond à sa dimension perpendiculaire à la face du support sur lequel la première portion 104 est disposée et est parallèle à l'axe Z représenté sur la figure 1. L'épaisseur de la première portion 104 est par exemple comprise entre environ 20 nm et 10 µm, et de préférence comprise entre environ 2 µm et 4 µm.

Selon un premier exemple de réalisation, la première portion 104 comporte un seul semi-conducteur dopé, par exemple dopé n avec une concentration de donneurs par exemple comprise entre environ 10¹⁷ et 5.10²⁰ donneurs/cm³, et correspondant par exemple à du GaN.

Selon un deuxième exemple de réalisation, la première portion 104 est formée d'un empilement de plusieurs semi-conducteurs différents, par exemple un premier semi-conducteur dopé n+ avec une concentration de donneurs par exemple comprise entre environ 5.10¹⁷ et 5.10²⁰ donneurs/cm³ et un deuxième semi-conducteur dopé n- avec une concentration de donneurs par exemple comprise entre environ 10¹⁷ et 5.10¹⁹ donneurs/cm³. Le premier semi-conducteur est par exemple du GaN et le deuxième semi-conducteur est par exemple de I'lnGaN. L'épaisseur du premier semi-conducteur peut être supérieure à environ 100 nm, par exemple égale à environ 3 µm, et celle du deuxième semi-conducteur est par exemple comprise entre environ 5 nm et 500 nm. En variante, les différents semi-conducteurs de la première portion 104 peuvent être dopés avec un même niveau de dopage.

Dans l'exemple de réalisation particulier décrit ici dans lequel les composants 102 correspondent à des LEDs, chaque composant 102 comporte également une région émissive 106 comprenant une ou plusieurs couches émissives, par exemple cinq, destinées à former chacune un puits quantique, comprenant par exemple de I'lnGaN, et chacune disposée entre deux couches barrières comprenant par exemple du GaN. La ou les couches émissives comportent des matériaux semi-conducteurs intrinsèques, c'est-à-dire non intentionnellement dopés (de concentration en donneurs résiduels n_{nid} par exemple égale à environ 10¹⁷ donneurs/cm³, ou comprise entre environ 10¹⁵ et 10¹⁸ donneurs/cm³). L'épaisseur (dimension selon l'axe Z) de la ou de chacune des couches émissives est par exemple égale à environ 3 nm et plus généralement comprise entre environ 0,5 nm et 10 nm, et l'épaisseur (dimension selon l'axe Z) de chacune des couches barrières est par exemple comprise entre environ 1 nm et 25 nm.

En variante, il est possible que les composants 102 ne comportent pas les régions émissives 106.

Chaque composant 102 comporte également une deuxième portion 108 de semi-conducteur dopé selon un deuxième type de conductivité, opposé à celui du dopage de la première portion 104 et ici de type p, avec une concentration d'accepteurs par exemple comprise entre environ 10¹⁷ et 5.10¹⁹ accepteurs/cm³. Le semi-conducteur de la deuxième portion 108 est par exemple du GaN et son épaisseur (dimension selon l'axe Z) est par exemple comprise entre environ 20 nm et 10 µm.

La région émissive 106 est disposée entre la première portion 104 et la deuxième portion 108.

Les portions 104 et 108 forment des jonctions p-n des composants 102. Les portions 104, 108 et la région émissive 106 forment ensemble une jonction p-i-n.

En variante, les types de conductivité des semi-conducteurs des portions 104 et 108 peuvent être inversés par rapport à l'exemple décrit ici.

Dans une variante de réalisation, une couche de blocage d'électrons (non visible sur les figures 1 à 21) peut être disposée entre la deuxième portion 108 et la région émissive 106, cette couche de blocage d'électrons comprenant par exemple de l'AIGaN avec 12% d'aluminium et dopé p avec une concentration d'accepteurs par exemple égale à environ 10¹⁷ accepteurs/cm³.

Des matériaux autres que ceux cités ci-dessus peuvent être utilisés pour réaliser les portions 104, 108 et la région émissive 106.

Dans chaque composant 102, les portions 104, 108 et la région émissive 106 forment un empilement de semi-conducteurs correspondant à une structure mesa. L'expression « structure mesa » désigne le fait que le composant 102 est réalisé sous la forme d'un empilement des portions 104, 108 de semi-conducteurs dopés, une zone de jonction étant formée à l'interface de ces deux portions 104, 108 de semi-conducteurs dopés, et que cet empilement est ici gravé sur toute sa hauteur sous forme d'un îlot appelé mesa.

Les dimensions des côtés (dimensions dans le plan (X,Y)) d'une des structures mesa formées par les composants 102 peuvent être comprises entre environ 500 nm et 1 mm, ou entre 500 nm et plusieurs millimètres, selon les applications visées et la densité de pixels souhaitée. Par exemple, pour des applications faisant appel à des diodes de forte puissance (par exemple des matrices de LED pour phares de voiture), les dimensions des diodes sont plus importantes (quelques dizaines de microns) que dans des applications faisant appel à des diodes de plus faible puissance, comme par exemple le domaine des écrans (généralement inférieures à une dizaine de microns).

Chaque composant 102 comporte une première électrode 110 recouvrant, ou disposée contre, des flancs latéraux d'un empilement semi-conducteur du composant 102 formé par les portions 104, 108 et la région émissive 106, et s'étendant sur toute la hauteur de la structures mesa formée par le composant 102 jusqu'à une face 112 émettrice et/ou réceptrice du composant 102. La première électrode 110 correspond par exemple à la cathode du composant 102. La première électrode 110 comporte ici une partie centrale 114 comprenant par exemple du cuivre, et une couche extérieure 116 recouvrant la partie centrale 114 et comprenant par exemple du titane d'épaisseur par exemple comprise entre environ 5 nm et 300 nm et de l'aluminium d'épaisseur par exemple comprise entre environ 50 nm et 1 µm. De manière avantageuse, l'épaisseur de la couche extérieure 116 est égale à environ 400 nm.

La largeur de la première électrode 110, correspondant à la dimension selon l'axe X représenté sur la figure 1, est inférieure à la dimension d'un côté d'un composant 102 dans le plan (X,Y) et est par exemple comprise entre environ 1 µm et 20 µm, ou entre environ 3 µm et 6 µm, et par exemple égale à environ 5 µm.

Dans le premier mode de réalisation décrit ici, les premières électrodes 110 sont couplées électriquement entre elles pour former une électrode commune (par exemple une cathode) à plusieurs composants 102 du dispositif 100. Les premières électrodes 110 forment ensemble une grille dont les portions entourent les empilements semi-conducteurs de ces composants 102.

Dans le dispositif 100, les premières électrodes 110 servent également à isoler optiquement les composants 102 les uns des autres. La couche extérieure 116, notamment lorsqu'elle comporte de l'aluminium, permet notamment d'avoir une bonne réflexion optique sur les flancs latéraux des structures mesa et limite donc la diaphonie entre les composants 102 voisins.

Chaque composant 102 comporte également des portions diélectriques 118 qui recouvrent des flancs latéraux d'une première partie 120 de la première portion 104, des flancs latéraux de la région émissive 106 et des flancs latéraux de la deuxième portion 108. Les portions diélectriques 118 comportent par exemple un bicouche SiN/SiO₂, et ont par exemple une épaisseur, ou largeur, comprise entre environ 3 nm et 2 µm et par exemple égale à environ 200 nm. Ces portions diélectriques 118 assurent l'isolation électrique entre la première électrode 110 et la deuxième portion 108, et entre la première électrode 110 et la région émissive 106.

Les portions diélectriques 118 ne recouvrent pas les flancs latéraux d'une deuxième partie 122 de la première portion 104 (la première partie 120 étant disposée entre la deuxième partie 122 et la deuxième portion 108). Ainsi, la première électrode 110 est en contact électriquement avec la deuxième partie 122 de la première portion 104. Sur les figures 1 à 21, les premières et deuxièmes parties 120, 122 de la première portion 104 sont délimitées symboliquement l'une de l'autre par un trait pointillé.

Chaque composant 102 comporte également une deuxième électrode 124, correspondant par exemple à l'anode, reliée électriquement à la deuxième portion 108 et telle que la deuxième portion 108 soit disposée entre la deuxième électrode 124 et la première portion 104. La deuxième électrode 124 comporte par exemple un matériau optiquement réflecteur tel que de l'aluminium, ou l'argent. Ce matériau est qualifié d'optiquement réflecteur car il présente un coefficient de réflexion en amplitude (rapport de l'amplitude de la lumière réfléchie sur l'amplitude de la lumière incidente) d'au moins 80 %.

La distance entre deux composants 102 voisins, c'est-à-dire la somme de l'épaisseur d'une portion de la première électrode 110 et des épaisseurs de deux portions diélectriques 118, est par exemple supérieure ou égale à environ 0,5 µm.

Chaque composant 102 comporte également des portions diélectriques 126 assurant l'isolation électrique entre la première électrode 110 et la deuxième électrode 124.

Les composants 102 comportent leurs électrodes 110, 124 accessibles depuis une face arrière 128 opposée à la face émissive 112.

Les composants 102 sont reportés, au niveau de leur face arrière 128, sur un circuit électronique de commande 130 auquel les électrodes 110, 124 des composants 102 sont couplées électriquement. Ce report permet de coupler électriquement et mécaniquement les composants 102 au circuit 130. Le circuit 130 comporte un substrat sur lequel des composants d'adressage actif par exemple de type CMOS ou passif (réseau d'interconnexion) sont notamment réalisés. Des plots électriquement conducteurs 132 permettent d'accéder électriquement aux composants du circuit 130 depuis l'extérieur du dispositif 100. Le report des composants 102 sur le circuit électronique de commande 130 est réalisé par hybridation, par exemple par brasage ou collage direct entre des plots de contact du circuit 130 et des plots de contacts 134 formés entre les composants 102 et le circuit 130. Les plots de contact comportent par exemple du cuivre.

Des détails de réalisation des composants 102 sont décrits dans le document WO 2017/068029 A1.

Après la réalisation des composants 102, un traitement de la face des premières électrodes 110 se trouvant du côté de la face émissive 112 est mis en œuvre pour rendre mouillable cette face des premières électrodes 110. En effet, le matériau présent en surface des premières électrodes 110, correspondant ici au métal de la couche extérieur 116, n'est généralement pas mouillable, comme c'est le cas de l'aluminium, ou pas suffisamment mouillable.

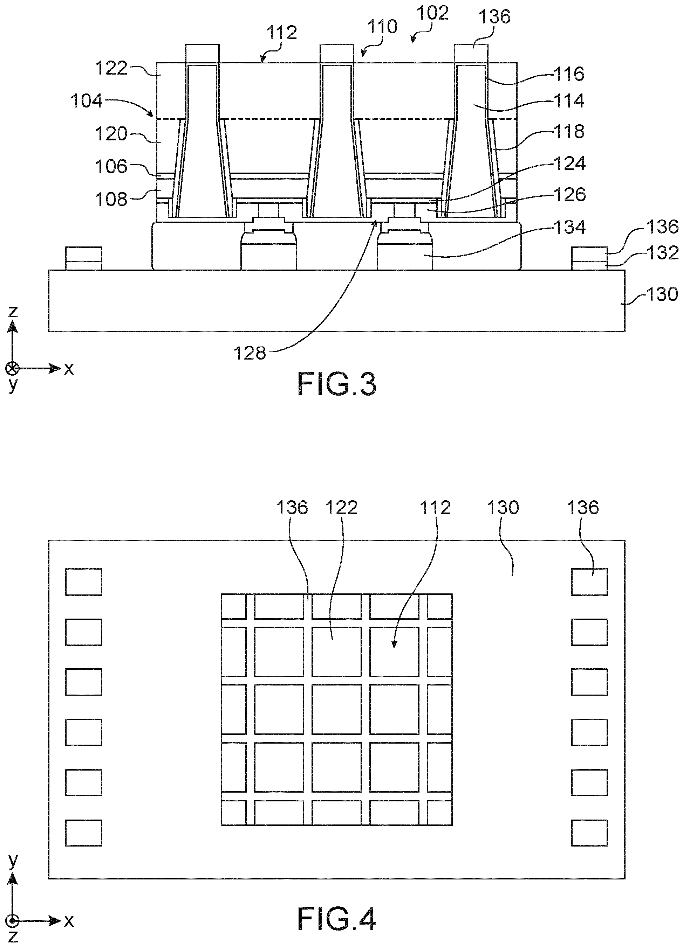

Selon un premier exemple, ce traitement comporte un dépôt d'au moins un matériau mouillable sur la face traitée de la première électrode 110, c'est-à-dire sur la face de la première électrode 110 sur laquelle une grille de séparation optique 140 est destinée à être réalisée. Le matériau mouillable correspond par exemple à un bicouche de type Ni/Au. Le matériau mouillable est par exemple déposé par un dépôt dit « electroless », c'est-à-dire ne faisant pas appel à un courant électrique pour assurer le dépôt du matériau. En variante, il est possible de réaliser le dépôt d'un matériau mouillable correspondant à un multicouche Ti/Ni/Au par exemple par une technique dite « lift off » ou tout autre procédé utilisant des procédés classiques de dépôt métallique et photolithographie. La structure obtenue à l'issue d'un tel traitement selon ce premier exemple est représentée sur les figures 3 et 4, la référence 136 désignant les portions du matériau mouillable déposées sur les premières électrodes 110 (sur ces figures, le matériau mouillable est également déposé sur les plots 132).

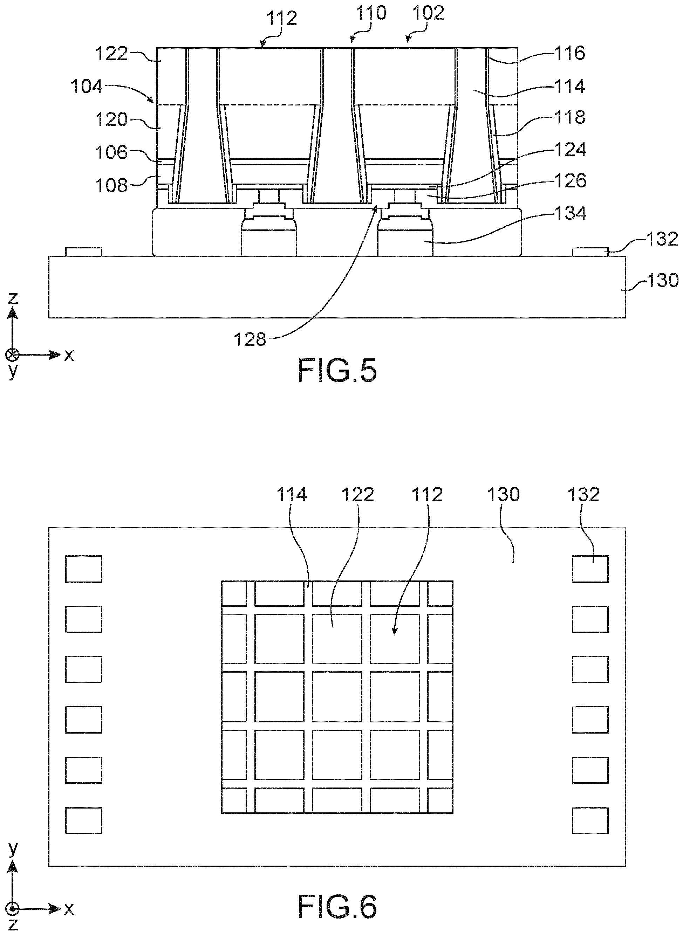

Selon un deuxième exemple, lorsque la première électrode 110 comporte un matériau mouillable recouvert par un matériau non mouillable (comme c'est le cas ici avec le cuivre de la partie centrale 114 qui est recouvert par le titane et l'aluminium de la couche extérieure 116), le traitement peut comporter une gravure du matériau non mouillable de la première électrode 110 afin de révéler le matériau mouillable de la première électrode 110. Une telle gravure est par exemple mise en œuvre en utilisant un plasma, avantageusement de SF₆ et/ou un plasma chloré, pour supprimer le ou les métaux de la couche extérieure 116 de la première électrode 110. Lors de cette gravure, les plots 132 sont recouverts de résine de protection afin qu'ils ne soient pas altérés par cette gravure. Cette résine est ensuite supprimée. En variante, il est possible de mettre en œuvre une gravure par faisceau d'ions. La structure obtenue à l'issue d'un tel traitement est représentée sur les figures 5 et 6.

Parallèlement au traitement de la première électrode 110, la grille de séparation optique métallique 140 destinée à être reportée sur la première électrode 110 est réalisée.

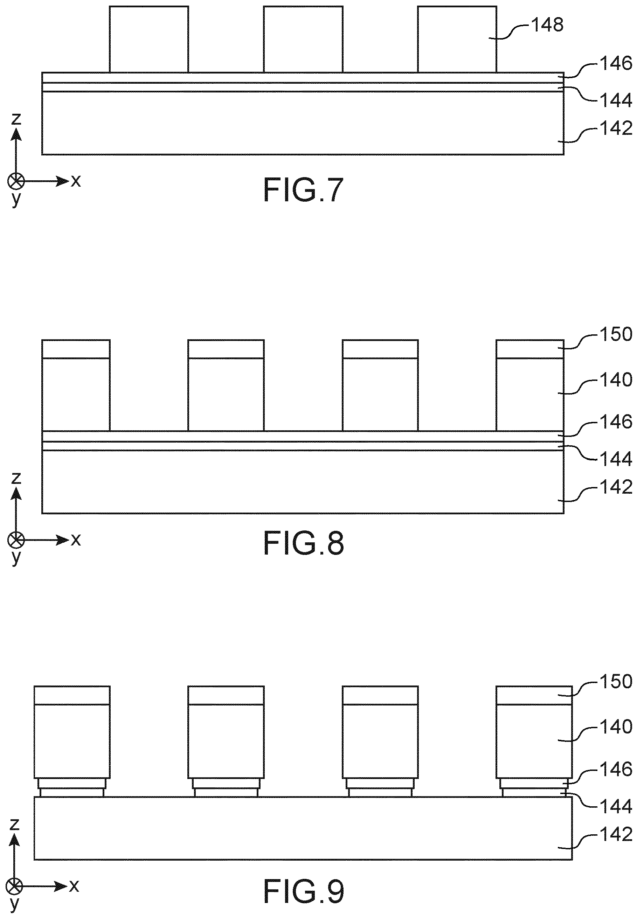

Un premier exemple de réalisation de la grille de séparation optique 140 est décrit ci-dessous en lien avec les figures 7 à 10.

La grille de séparation optique 140 est réalisée à partir d'un support 142, qui correspond par exemple à un substrat de semi-conducteur, ici un substrat de silicium. Le support 142 correspond ici à un wafer de silicium de diamètre égal à 200 mm.

Une couche sacrificielle 144 est formée sur la face du support 142 du côté de laquelle la grille de séparation optique 140 est destinée à être réalisée. Le matériau de la couche sacrificielle 144 est ici apte à être gravé sélectivement vis-à-vis du matériau de la grille de séparation optique 140. Dans l'exemple de réalisation décrit ici, la couche sacrificielle 144 correspond à une couche de titane. L'épaisseur (dimension selon l'axe Z) de la couche sacrificielle 144 est ici égale à environ 50 nm.

Une couche de croissance métallique 146, à partir de laquelle le matériau de la grille de séparation optique 140 va être déposé, est ensuite formée sur la couche sacrificielle 144. Dans l'exemple de réalisation décrit ici, la couche de croissance 146 comporte du cuivre. La couche sacrificielle 144 sert également de couche d'accroche pour le dépôt de la couche de croissance 146. L'épaisseur (dimension selon l'axe Z) de la couche de croissance 146 est par exemple égale à environ 100 nm.

Le motif souhaité de la grille de séparation optique 140 est défini par un masque de résine 148 déposé sur la couche de croissance 146 (voir figure 7). Ce motif correspond à celui de la première électrode 110, c'est-à-dire ici celui d'une grille.

Le matériau métallique de la grille de séparation optique 140, par exemple du cuivre, est ensuite déposé à partir des portions de la couche de croissance 146 non recouvertes par le masque 148. Un tel dépôt correspond par exemple à un dépôt électrochimique, ou croissance ECD.

La largeur des portions de la grille de séparation optique 140 (dimension selon l'axe X visible sur la figure 8) est égale ou proche de celle des premières électrodes 110. La hauteur de la grille de séparation optique 140 (dimension selon l'axe Z visible sur la figure 8) est par exemple comprise entre environ 5 µm et 50 µm, et avantageusement comprise entre environ 10 µm et 20 µm.

Un matériau de brasure 150 est ensuite déposé sur le matériau métallique de la grille de séparation optique 140. Ce matériau de brasure 150 comporte par exemple au moins l'un des matériaux suivants : SnAg, In, Sn, SnCu, InSn. Le matériau de brasure 150 peut être déposé directement à la suite de la grille 140 par la même technique de dépôt électrochimique ECD ou postérieurement par un dépôt de type « liftoff », immersion, enduction, sérigraphie, etc. L'épaisseur (dimension selon l'axe Z) du matériau de brasure 150 est par exemple comprise entre environ 1 µm et 10 µm, et par exemple égale à environ 3 µm.

Le masque 148 est ensuite retiré (voir figure 8).

Les parties de la couche de croissance 146 et de la couche sacrificielle 144 qui étaient recouvertes par le masque 148 sont ensuite supprimées, par exemple par gravure chimique.

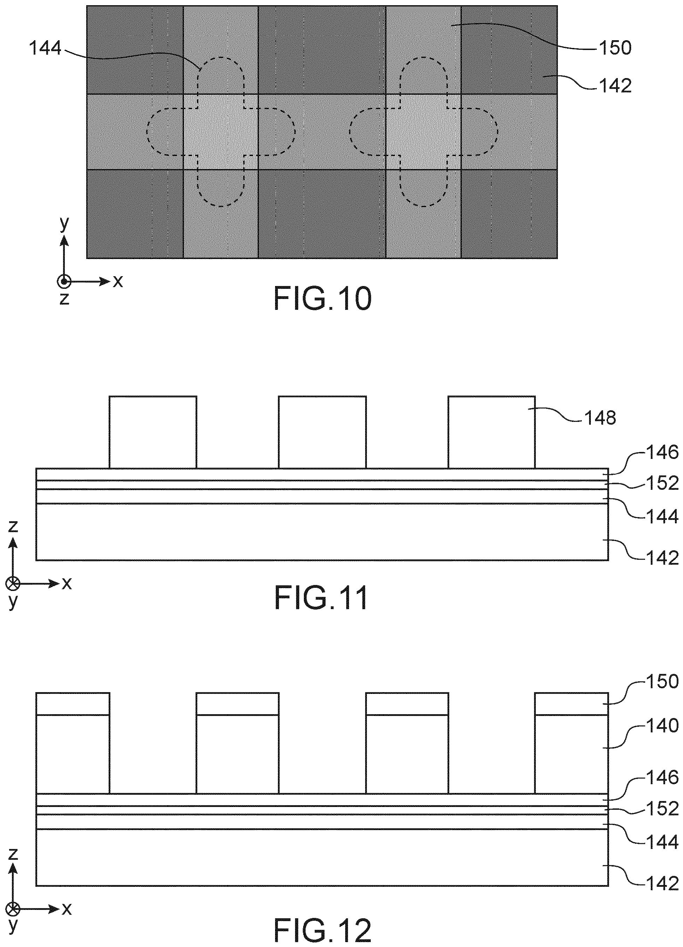

Afin de faciliter le retrait ultérieur du support 142 vis-à-vis de la grille de séparation optique 140, une étape de sur-gravure de la couche sacrificielle 144 est ensuite mise en œuvre. Cette sur-gravure de la couche sacrificielle 144 supprime des parties de la couche sacrificielle 144 présentes entre la grille de séparation optique 140 et le support 142 afin que les seules parties restantes de la couche sacrificielle 144 soient localisées aux intersections formées par la grille de séparation optique 140, comme cela est visible sur la figure 10.

Un deuxième exemple de réalisation avantageux de la grille de séparation optique 140 est décrit ci-dessous en lien avec les figures 11 à 13.

Comme dans le premier exemple de réalisation décrit précédemment, la grille de séparation optique 140 est réalisée à partir du support 142 sur lequel est réalisée la couche sacrificielle 144. Contrairement au premier exemple de réalisation dans lequel la couche sacrificielle 144 correspond à une couche de matériau apte à être gravé sélectivement et qui forme également une couche d'accroche pour la couche de croissance métallique 146, les fonctions de couche sacrificielle et de couche d'accroche sont ici remplies par deux couches distinctes. Dans ce deuxième exemple de réalisation, la couche sacrificielle 144 est disposée entre le support 142 et la couche d'accroche portant la référence 152 sur la figure 11. La couche d'accroche 152 est disposée entre la couche sacrificielle 144 et la couche de croissance métallique 146 qui est par exemple identique à celle précédemment décrite pour le premier exemple de réalisation.

La couche d'accroche 152 correspond par exemple à une couche de titane identique à la couche de sacrificielle précédemment décrite en lien avec le premier exemple de réalisation.

La couche sacrificielle 144 de ce deuxième exemple de réalisation peut être réalisée selon plusieurs variantes.

Selon une première variante, la couche sacrificielle 144 peut comporter un matériau apte à être dissous dans un solvant. Un tel matériau correspond par exemple à une résine adhésive temporaire par exemple commercialisée par la société Brewer Science et de type BrewerBOND^{®} 220 ou 305 et qui est soluble dans une solution de limonène.

Selon une deuxième variante, la couche sacrificielle 144 peut comporter du polyimide. Le polyimide est un polymère commercialisé par exemple par la société HD MicroSystems de référence PI-2610, ayant une épaisseur par exemple comprise entre 1 µm et 2,5 µm et par exemple égale à environ 2 µm et qui peut être retiré par un plasma oxygène, ou de référence PI-2611 dont l'épaisseur est par exemple comprise entre 3 µm et 9 µm. Le polymère a par exemple ici un coefficient de dilatation thermique, ou CTE, proche de celui du silicium.

La grille de séparation optique 140 est réalisée comme précédemment décrit pour le premier exemple de réalisation, c'est-à-dire en déposant le masque de résine 148 sur la couche de croissance 146 (voir figure 11), puis en déposant le matériau métallique de la grille de séparation optique 140 à partir des portion de la couche de croissance 146 non recouvertes par le masque 148, en formant le matériau de brasure 150 sur la grille de séparation optique 140 et en retirant le masque 148 (voir figure 12).

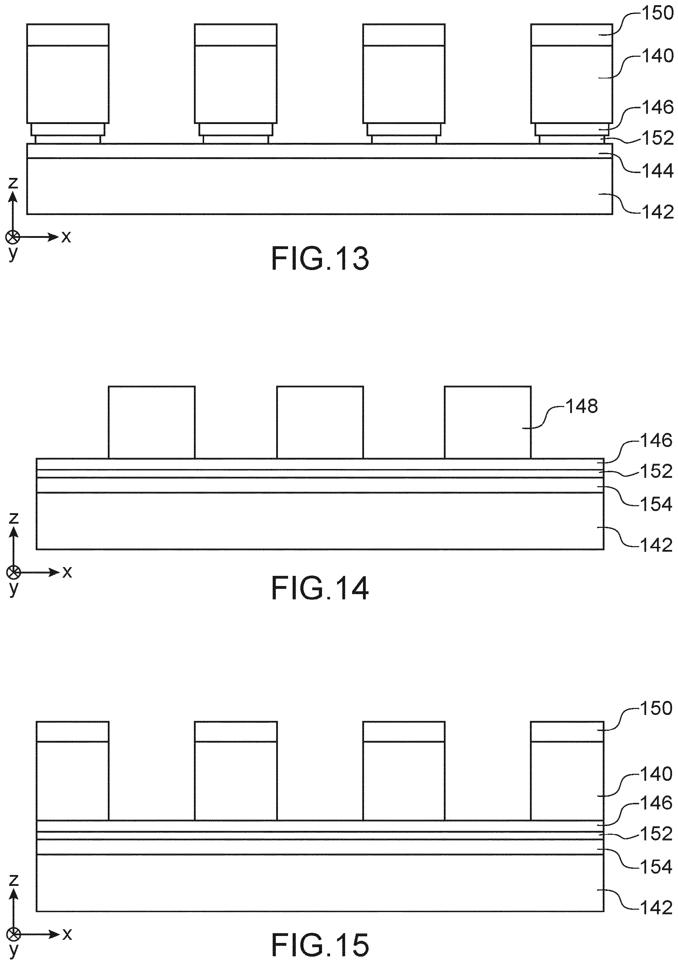

Les parties de la couche de croissance 146 et de la couche d'accroche 152 qui étaient recouvertes par le masque 148 sont ensuite supprimées, par exemple par gravure chimique (voir figure 13).

Un troisième exemple de réalisation avantageux de la grille de séparation optique 140 est décrit ci-dessous en lien avec les figures 14 à 16.

Dans ce troisième exemple de réalisation, le support 142 est recouvert d'une couche adhésive temporaire 154. La couche d'accroche 152 est réalisée sur la couche adhésive temporaire 154 et la couche de croissance 146 est réalisée sur la couche d'accroche 152. La couche d'accroche 152 et la couche de croissance 146 sont par exemple identiques à celles précédemment décrites pour le deuxième exemple de réalisation de la grille de séparation optique 140.

La couche adhésive temporaire 154 de ce troisième exemple de réalisation peut être réalisée selon plusieurs variantes.

Selon une première variante, la couche adhésive temporaire 154 comporte un matériau adhésif dont les propriétés adhésives se dégradent à une température donnée. La couche adhésive temporaire 154 est par exemple du type « Thermal Release Tape » commercialisé par exemple par la société Nitto Denko Corporation et appelé Revalpha^{®}, dont les propriétés adhésives se dégradent à une température supérieure ou égale à par exemple à 170°C. Le brasage permettant de solidariser la grille de séparation optique 140 à la première électrode 110 sera dans ce cas mis en œuvre à une température qui sera supérieure ou égale à la température de fusion du matériau de brasure 150 utilisé et également supérieure ou égale à la température donnée à partir de laquelle les propriétés adhésives de la couche adhésive temporaire 154 se dégradent. Lors du brasage, une montée en température rapide permet d'atteindre la fusion du matériau de brasure 150 utilisé avant le décollement complet de la couche adhésive temporaire 154. A l'issue du brasage, les propriétés adhésives de la couche adhésive temporaire 154 sont nulles ou presque nulles et le support 142 peut alors être séparé de la grille de séparation optique 140. Le cas échéant, si le décollement n'a pas pu être réalisé lors de l'opération de brasage, le décollement peut être réalisé par une nouvelle montée en température au-delà de laquelle les propriétés adhésives de la couche adhésive temporaire 154 se dégradent. Dans une telle variante, le matériau de brasure 150 comporte avantageusement une température de fusion basse et correspond par exemple à du Sn-Ag, de l'In, de l'InSn ou du Sn pur. Toutefois, grâce à l'énergie de collage, d'autres matériaux de brasure 150 peuvent être utilisés.

Selon une deuxième variante, la couche adhésive temporaire 154 comporte un matériau dont les propriétés adhésives se dégradent lorsque ledit matériau est exposé à un rayonnement électromagnétique. Un tel matériau correspond par exemple à du LTHC (Light to Heat Conversion Coating) commercialisé par la société 3M^{®} dont les propriétés adhésives se dégradent avec un rayonnement IR obtenu avec un laser YAG, ou est de type BrewerBOND^{®} 701 commercialisé par la société Brewer Science, ou de type HD-3007 commercialisé par la société HD Microsystems dont les propriétés adhésives se dégradent avec un rayonnement UV obtenu par exemple avec un laser excimer, ou bien en utilisant un solvant ou par chauffage. Dans ce cas, le retrait du support 142 comportera une exposition de la couche adhésive temporaire 154 au rayonnement utilisé à travers le support 142. Dans cette variante, le support 142 est donc choisi tel qu'il soit transparent ou au moins partiellement transparent au rayonnement utilisé.

La grille de séparation optique 140 est ensuite réalisée comme précédemment décrit pour les premier et deuxième exemples de réalisation, c'est-à-dire en déposant le masque de résine 148 sur la couche de croissance 146 (voir figure 14), puis en déposant le matériau métallique de la grille de séparation optique 140 à partir des portions de la couche de croissance 146 non recouvertes par le masque 148, en formant le matériau de brasure 150 sur la grille de séparation optique 140 et en retirant le masque 148 (voir figure 15).

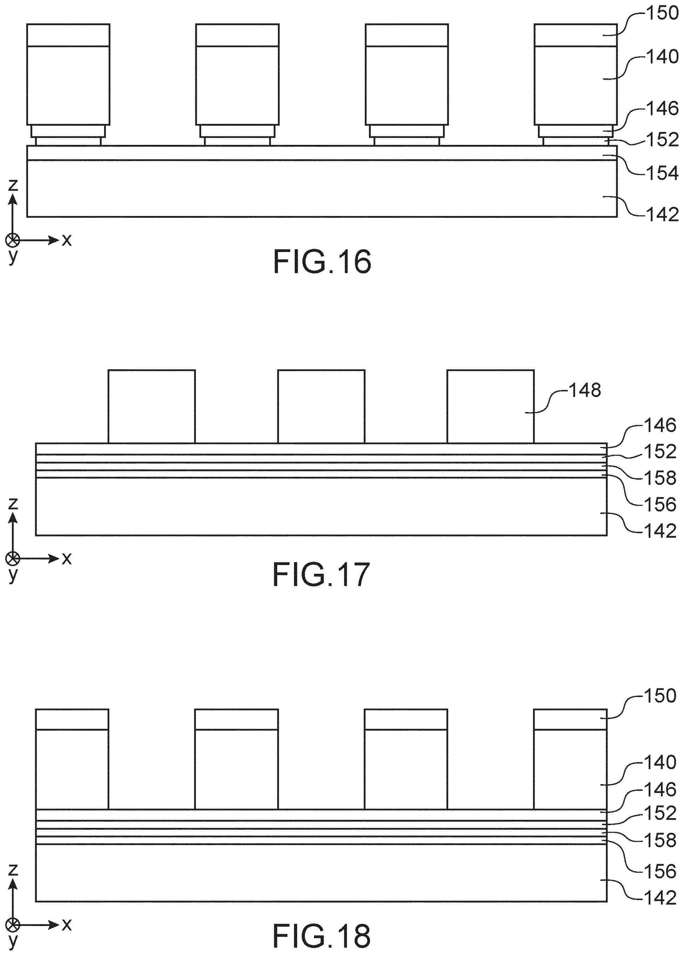

Les parties de la couche de croissance 146 et de la couche d'accroche 152 qui étaient recouvertes par le masque 148 sont ensuite supprimées, par exemple par gravure chimique (voir figure 16).

Un quatrième exemple de réalisation de la grille de séparation optique 140 est décrit ci-dessous en lien avec les figures 17 à 19.

Dans ce quatrième exemple de réalisation, le support 142 est recouvert d'une couche d'oxyde 156 sur laquelle est déposée ensuite une couche de platine 158. La couche d'accroche 152 est réalisée sur la couche de platine 158 et la couche de croissance 146 est réalisée sur la couche d'accroche 152. La couche d'accroche 152 et la couche de croissance 146 sont par exemple identiques à celles précédemment décrites pour les deuxième et troisième exemples de réalisation de la grille de séparation optique 140.

L'interface formée entre la couche d'oxyde 156 et la couche de platine 158 a une faible adhérence qui permettra ultérieurement de désolidariser le support 142 vis-à-vis de la grille de séparation optique 140 en séparant mécaniquement la couche d'oxyde 156 vis-à-vis de la couche de platine 158.

La grille de séparation optique 140 est réalisée comme précédemment décrit pour les précédents exemples de réalisation, c'est-à-dire en déposant le masque de résine 148 sur la couche de croissance 146 (voir figure 17), puis en déposant le matériau métallique de la grille de séparation optique 140 à partir des portions de la couche de croissance 146 non recouvertes par le masque 148, en formant le matériau de brasure 150 sur la grille de séparation optique 140 et en retirant le masque 148 (voir figure 18).

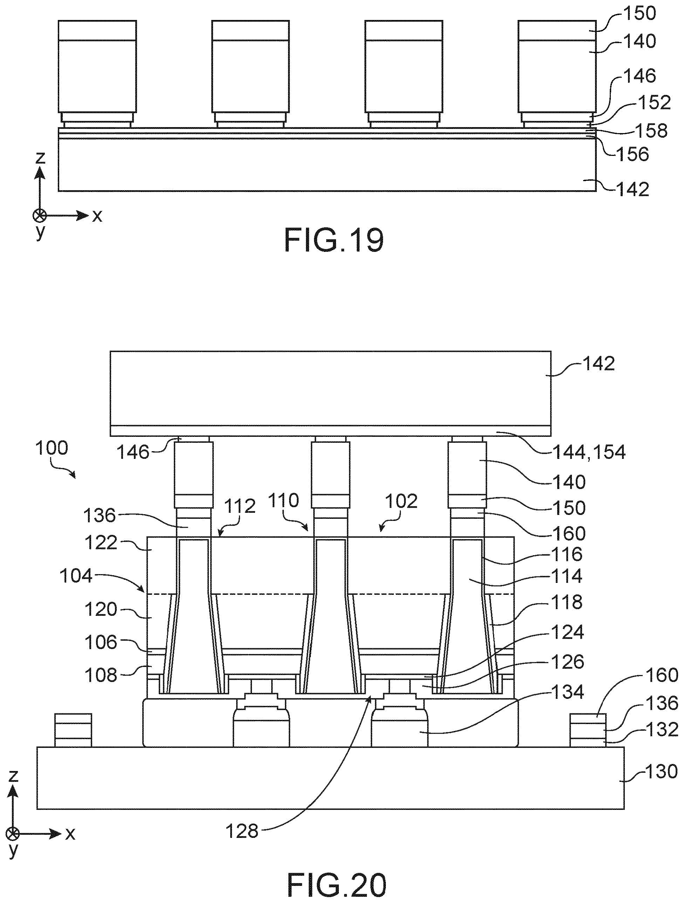

Les parties de la couche de croissance 146 et de la couche d'accroche 152 qui étaient recouvertes par le masque 148 sont ensuite supprimées, par exemple par gravure chimique (voir figure 19).

Pour les différents exemples de réalisation de la grille de séparation optique 140 décrits précédemment, il est possible de mettre en oeuvre, entre les étapes de dépôt du matériau métallique de la grille de séparation optique 140 et l'étape de dépôt du matériau de brasure 150, une étape de dépôt d'un second matériau recouvrant notamment les parois latérales du premier matériau métallique de la grille de séparation optique 140. Ce second matériau de la grille de séparation optique 140, recouvrant le premier matériau de la grille de séparation optique 140, est avantageusement un matériau métallique, par exemple de l'argent pouvant être déposé par un dépôt dit « electroless », ou par pulvérisation ou dépôt PVD, améliorant la réflectivité des parois latérales de la grille de séparation optique 140 et protégeant le premier matériau d'une oxydation.

Après avoir réalisé la grille de séparation optique 140, cette grille 140 est solidarisée par brasage contre la face de la première électrode 110 qui a subie au préalable le traitement la rendant mouillable (voir figure 20). Ce brasage est réalisé par l'intermédiaire du matériau de brasure 150, à une température supérieure à la température de fusion de ce matériau de brasure 150, par exemple à environ 250°C. Il est possible qu'un matériau de brasure 160 soit déposé au préalable sur la première électrode 110, comme c'est le cas sur la figure 20.

Lorsque le ou les matériaux de brasure utilisés sont dans un état de fusion, un auto-alignement se produit entre la grille de séparation optique 140 et les portions métalliques de la première électrode 110.

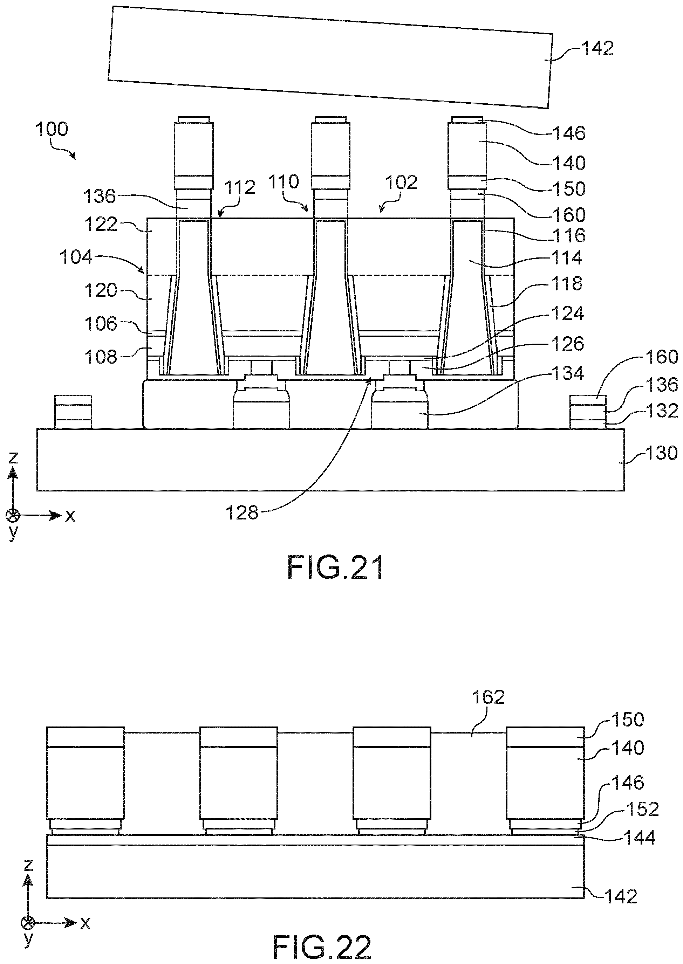

Enfin, le support 142 est retiré et détaché de la grille de séparation optique 140, achevant la réalisation du dispositif 100 (voir figure 21). La technique mise en œuvre pour réaliser ce retrait dépend de la nature de la ou des couches formant l'interface entre le support 142 et la grille de séparation optique 140 :
- dans le cas d'une couche sacrificielle 144 telle que décrite précédemment dans le premier exemple de réalisation de la grille de séparation optique 140, une gravure chimique est par exemple mise en œuvre pour supprimer les portions restantes de la couche sacrificielle 144 localisées aux intersections formées par la grille de séparation optique 140 ;
- dans le cas d'une couche sacrificielle 144 comprenant un matériau apte à être dissous dans un solvant, l'assemblage réalisé peut être plongé dans une solution chimique comprenant ce solvant, entraînant la dissolution de la couche sacrificielle 144. Il est dans ce cas avantageux que le support 142 comporte des trous formant des accès, pour le solvant, à la couche sacrificielle 144 depuis la face opposée à celle sur laquelle se trouve la couche sacrificielle 144 ;

- dans le cas d'une couche sacrificielle 144 comprenant du polyimide, l'assemblage réalisé peut être soumis à un plasma comprenant par exemple de l'oxygène, permettant de graver la couche sacrificielle 144. Là encore, il est avantageux que le support 142 comporte des trous formant des accès, pour le plasma, à la couche sacrificielle 144 depuis la face opposée à celle sur laquelle se trouve la couche sacrificielle 144 ;
- dans le cas d'une couche adhésive temporaire 154 comportant un matériau adhésif dont les propriétés adhésives se dégradent à une température donnée, le support 142 peut être retiré dès la fin du brasage du fait que la température atteinte lors de ce brasage supprime les propriétés adhésives de la couche adhésive temporaire 154 ;
- dans le cas d'une couche adhésive temporaire 154 comportant un matériau dont les propriétés adhésives se dégradent lorsque ledit matériau est exposé à un rayonnement électromagnétique (par exemple UV ou IR), une exposition de ce matériau à ce rayonnement par laser est réalisée à travers le support 142 ;
- dans le cas d'une interface formée par une couche d'oxyde 156 et une couche de platine 158, une force mécanique appliquée à l'interface de ces couches permet de les séparer l'une de l'autre. Il convient alors de graver la couche de platine 158 ou alors de l'avoir préalablement gravée à la suite des opérations de gravures comme indiqué précédemment en lien avec la figure 19.

Selon un deuxième mode de réalisation, il est possible que lors de la réalisation de la grille de séparation optique 140, après le retrait du masque 148, un ou plusieurs éléments 162 de conversion en longueur d'onde d'un rayonnement destiné à être émis et/ou reçu par le composant 102 soit disposé entre des portions de la grille de séparation optique 140. Un tel élément 162 peut être couplé à un ou plusieurs composants 102 sur dispositif 100, ou tous les composants 102 du dispositif 100. La figure 22 représente la grille de séparation optique 140 ainsi que les composants 102 auxquels les éléments 162 sont associés.

Les éléments 162 peuvent comporter du phosphore, comme par exemple des particules de phosphore disposées dans une matrice de verre de type solgel ou encore polymère de type silicone et/ou acrylique par exemple.

La solidarisation est dans ce cas mise en œuvre à une température ne dégradant pas ces éléments 162.

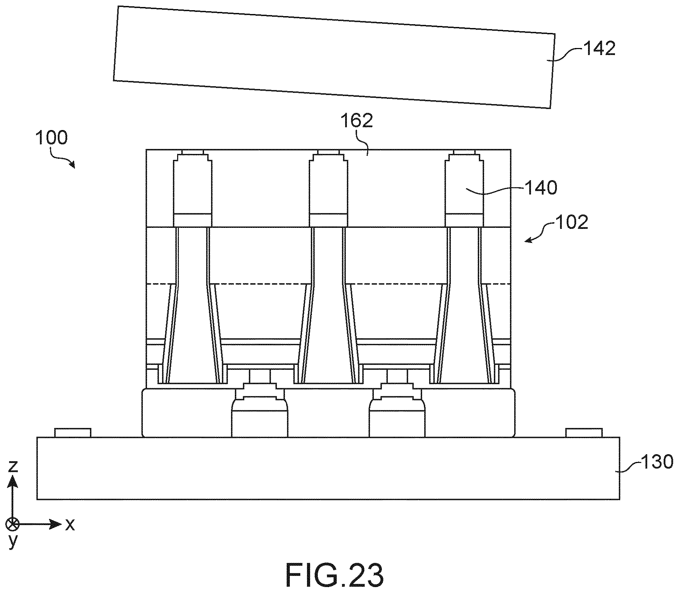

Après la solidarisation de la grille de séparation optique 140 aux premières électrodes 110, les éléments de conversion en longueur d'onde se retrouvent disposés en regard des empilements semi-conducteurs des composants 102, comme cela est visible sur la figure 23.

Dans les premier et deuxième modes de réalisation particulier décrits précédemment, les composants 102 sont couplés électriquement au circuit électronique de commande 130, puis les grilles de séparation optique 140 sont ensuite reportées sur les premières électrodes 110 des composants 102. En variante, il est possible que les grilles de séparation optique 140 soient d'abord reportées sur les premières électrodes 110 des composants 102, puis ces composants 102 (qui incluent les grilles de séparation optique 140) peuvent ensuite être couplés au circuit électronique de commande 130.

Pour tous les modes et variantes de réalisation précédemment décrits, le procédé de réalisation du dispositif 100 peut être mis en œuvre de différentes façons :
- puce à puce, c'est-à-dire en couplant individuellement chacun des dispositifs 100 à une grille de séparation optique indépendante, ou
- puce à substrat, c'est-à-dire en réalisant plusieurs dispositifs 100 puis en les solidarisant sur un support commun et enfin en assemblant collectivement les grilles de séparation optique 140 aux premières électrodes 110 de ces dispositifs 100, ou
- substrat à substrat, c'est-à-dire en réalisant plusieurs dispositifs 100 sur un premier substrat et en assemblant ensuite les premières électrodes 110 de ces dispositifs 100 à des grilles de séparation optique 140 réalisées sur un deuxième substrat.

## Revendications

1. Procédé de réalisation d'un dispositif photo-émetteur et/ou photo-récepteur (100) à grille de séparation optique métallique (140), comprenant au moins :
- réalisation d'au moins un composant photo-émetteur et/ou photo-récepteur (102), dans lequel au moins une première électrode métallique (110) du composant photo-émetteur et/ou photo-récepteur (102) recouvre des flancs latéraux d'au moins un empilement semi-conducteur (104, 106, 108) du composant photo-émetteur et/ou photo-récepteur (102) et s'étend jusqu'à au moins une face émettrice et/ou réceptrice (112) du composant photo-émetteur et/ou photo-récepteur (102) ;
- traitement d'au moins une face de la première électrode métallique (110) localisée au niveau de la face émettrice et/ou réceptrice (112), rendant mouillable ladite face de la première électrode métallique (110) ;
- réalisation de la grille de séparation optique métallique (140) sur au moins un support (142) ;
- solidarisation de la grille de séparation optique métallique (140) contre ladite face de la première électrode métallique (110) par brasage ;
- retrait du support (142).

2. Procédé selon la revendication 1, dans lequel le composant photo-émetteur et/ou photo-récepteur (102) comporte au moins une diode photo-émettrice et/ou photo-réceptrice comprenant au moins :
- des première et deuxième portions (104, 108) de semi-conducteurs dopés faisant partie de l'empilement semi-conducteur et formant une jonction p-n, une première partie (120) de la première portion (104) de semi-conducteur dopé étant disposée entre une deuxième partie (122) de la première portion (104) de semi-conducteur dopé et la deuxième portion (108) de semi-conducteur dopé ;
- des portions diélectriques (118) recouvrant des flancs latéraux de la première partie (120) de la première portion (104) de semi-conducteur dopé et des flancs latéraux de la deuxième portion (108) de semi-conducteur dopé ;
- une deuxième électrode (124) couplée électriquement à la deuxième portion (108) de semi-conducteur dopé et telle que la deuxième portion (108) de semi-conducteur dopé soit disposée entre la deuxième électrode (124) et la première portion (104) de semi-conducteur dopé ;
et dans lequel la première électrode métallique (110) est disposée contre des flancs latéraux extérieurs des portions diélectriques (118) et contre des flancs latéraux de la deuxième partie (122) de la première portion (104) de semi-conducteur dopé telle que la première électrode métallique (110) soit couplée électriquement à la première portion (104) de semi-conducteur dopé et isolée électriquement de la deuxième portion (108) de semi-conducteur dopé.

3. Procédé selon l'une des revendications précédentes, comportant en outre, entre la réalisation du composant photo-émetteur et/ou photo-récepteur (102) et le traitement de la face de la première électrode métallique (110), ou après le retrait du support (142), un couplage électrique et mécanique du composant photo-émetteur et/ou photo-récepteur (102), du côté opposé à la face émettrice et/ou réceptrice (112), à au moins un circuit électronique de commande (130).

4. Procédé selon l'une des revendications précédentes, dans lequel le traitement de la face de la première électrode métallique (110) comporte un dépôt d'au moins un matériau mouillable (136) sur la face de la première électrode métallique (110), ou, lorsque la première électrode métallique (110) comporte au moins un premier matériau métallique mouillable (114) recouvert par au moins un deuxième matériau non mouillable (116), une gravure du deuxième matériau non mouillable (116) présent sur la face de la première électrode métallique (110).

5. Procédé selon l'une des revendications précédentes, comportant en outre, entre la réalisation de la grille de séparation optique métallique (140) et la solidarisation de la grille de séparation optique métallique (140), le dépôt d'au moins un matériau de brasure (150) sur la grille de séparation optique métallique (140).

6. Procédé selon l'une des revendications précédentes, dans lequel la grille de séparation optique métallique (140) est réalisée sur le support (142) avec au moins une couche sacrificielle (144) disposée entre la grille de séparation optique métallique (140) et le support (142), et dans lequel le retrait du support (142) est réalisé en supprimant la couche sacrificielle (144).

7. Procédé selon la revendication 6, dans lequel :
- le matériau de la couche sacrificielle (144) est apte à être gravé sélectivement vis-à-vis du matériau de la grille de séparation optique métallique (140) ;
- le procédé comporte en outre, entre la réalisation de la grille de séparation optique métallique (140) et la solidarisation de la grille de séparation optique métallique (140), une gravure partielle de la couche sacrificielle (144) telle que des portions restantes de la couche sacrificielle (144) soient localisées entre la grille de séparation optique métallique (140) et le support (142) ;
- le retrait du support (142) est réalisé en supprimant les portions restantes de la couche sacrificielle (144).

8. Procédé selon la revendication 6, dans lequel :
- la couche sacrificielle (144) comporte au moins un matériau apte à être dissous dans un solvant, et dans lequel le retrait du support (142) comporte au moins une mise en contact de la couche sacrificielle (144) avec le solvant engendrant une dissolution du matériau de la couche sacrificielle (144), ou
- la couche sacrificielle (144) comporte au moins du polyimide, et dans lequel le retrait du support (142) comporte au moins une mise en contact de la couche sacrificielle (144) avec un plasma engendrant une gravure du polyimide.

9. Procédé selon l'une des revendications 1 à 5, dans lequel :
- la grille de séparation optique métallique (140) est réalisée sur le support (142) avec au moins une couche adhésive temporaire (154) disposée entre la grille de séparation optique métallique (140) et le support (142) ;
- la couche adhésive temporaire (154) comporte au moins un matériau dont les propriétés adhésives sont aptes à se dégrader à partir d'une température donnée à laquelle est exposé ledit matériau, et la solidarisation de la grille de séparation optique métallique (140) est mise en œuvre à une température supérieure ou égale à ladite température donnée.

10. Procédé selon l'une des revendications 1 à 5, dans lequel :
- la grille de séparation optique métallique (140) est réalisée sur le support (142) avec au moins une couche adhésive temporaire (154) disposée entre la grille de séparation optique métallique (140) et le support (142) ;
- la couche adhésive temporaire (154) comporte au moins un matériau dont les propriétés adhésives sont aptes à se dégrader lorsque ledit matériau est exposé à un rayonnement électromagnétique, et le retrait du support (142) comporte au moins une exposition de la couche adhésive temporaire (154) au rayonnement électromagnétique à travers le support (142).

11. Procédé selon l'une des revendications 1 à 5, dans lequel :
- la grille de séparation optique métallique (140) est réalisée sur le support (142) avec au moins une couche d'oxyde (156) et au moins une couche de platine (156) disposées entre la grille de séparation optique métallique (140) et le support (142) ;
- le retrait du support (142) comporte au moins une séparation mécanique à l'interface entre la couche d'oxyde (156) et la couche de platine (158).

12. Procédé selon l'une des revendications précédentes, dans lequel la réalisation de la grille de séparation optique métallique (140) comporte en outre la réalisation, sur le support (142), d'au moins un élément (162) de conversion en longueur d'onde d'un rayonnement destiné à être émis et/ou reçu par le composant photo-émetteur et/ou photo-récepteur (102), disposé entre des portions de la grille de séparation optique métallique (140) tel qu'après la solidarisation de la grille de séparation optique métallique (140), l'élément (162) de conversion en longueur d'onde soit disposé en regard de l'empilement semi-conducteur (104, 106, 108) du composant photo-émetteur et/ou photo-récepteur (102).

13. Procédé selon la revendication 12, dans lequel l'élément (162) de conversion en longueur d'onde comporte du phosphore.

14. Procédé selon l'une des revendications précédentes, dans lequel :
- plusieurs composants photo-émetteurs et/ou photo-récepteurs (102) sont réalisés et forment une matrice de pixels du dispositif photo-émetteur et/ou photo-récepteur (100) ;
- la première électrode métallique (110) est disposée autour de chacun des composants photo-émetteurs et/ou photo-récepteurs (102) et est commune aux composants photo-émetteurs et/ou photo-récepteurs (102).

## Patentansprüche

1. Verfahren zur Herstellung einer lichtemittierenden und/oder lichtempfangenden Vorrichtung (100) mit optischem Trenngitter aus Metall (140), das mindestens umfasst:
- Herstellen mindestens einer lichtemittierenden und/oder lichtempfangenden Komponente (102), wobei mindestens eine erste Metallelektrode (110) der lichtemittierenden und/oder lichtempfangenden Komponente (102) seitliche Flanken mindestens eines Halbleiterstapels (104, 106, 108) der lichtemittierenden und/oder lichtempfangenden Komponente (102) bedeckt und sich bis zu mindestens einer emittierenden und/oder empfangenden Fläche (112) der lichtemittierenden und/oder lichtempfangenden Komponente (102) erstreckt;
- Behandeln mindestens einer Fläche der ersten Metallelektrode (110), die im Bereich der emittierenden und/oder empfangenden Fläche (112) lokalisiert ist, wodurch die Fläche der ersten Metallelektrode (110) benetzbar gemacht wird;
- Herstellen des optischen Trenngitters aus Metall (140) auf mindestens einem Träger (142);
- festes Verbinden des optischen Trenngitters aus Metall (140) an der Fläche der ersten Metallelektrode (110) durch Löten;
- Entfernen des Trägers (142).

2. Verfahren nach Anspruch 1, wobei die lichtemittierende und/oder lichtempfangende Komponente (102) mindestens eine lichtemittierende und/oder lichtempfangende Diode aufweist, die mindestens umfasst:
- einen ersten und zweiten Abschnitt (104, 108) dotierter Halbleiter, die Teil des Halbleiterstapels sind und einen p-n-Übergang bilden, wobei ein erster Teil (120) des ersten Abschnitts (104) eines dotierten Halbleiters zwischen einem zweiten Teil (122) des ersten Abschnitts (104) eines dotierten Halbleiters und dem zweiten Abschnitt (108) des dotierten Halbleiters angeordnet ist;
- dielektrische Abschnitte (118), die seitliche Flanken des ersten Teils (120) des ersten Abschnitts (104) eines dotierten Halbleiters und seitliche Flanken des zweiten Abschnitts (108) eines dotierten Halbleiters bedecken;
- eine zweite Elektrode (124), die an den zweiten Abschnitt (108) des dotierten Halbleiters elektrisch gekoppelt ist und derart, dass der zweite Abschnitt (108) des dotierten Halbleiters zwischen der zweiten Elektrode (124) und dem ersten Abschnitt (104) des dotierten Halbleiters angeordnet ist;
und wobei die erste Metallelektrode (110) an äußeren seitlichen Flanken der dielektrischen Abschnitte (118) und an seitlichen Flanken des zweiten Teils (122) des ersten Abschnitts (104) des dotierten Halbleiters derart angeordnet ist, dass die erste Metallelektrode (110) an den ersten Abschnitt (104) des dotierten Halbleiters elektrisch gekoppelt und vom zweiten Abschnitt (108) des dotierten Halbleiters elektrisch isoliert ist.

3. Verfahren nach einem der vorangehenden Ansprüche, das ferner zwischen der Herstellung der lichtemittierenden und/oder lichtempfangenden Komponente (102) und der Behandlung der Fläche der ersten Metallelektrode (110) oder nach der Entfernung des Trägers (142) eine elektrische und mechanische Kopplung der lichtemittierenden und/oder lichtempfangenden Komponente (102) auf der der emittierenden und/oder empfangenden Fläche (112) gegenüberliegenden Seite an mindestens einen elektronischen Steuerschaltkreis (130) aufweist.

4. Verfahren nach einem der vorangehenden Ansprüche, wobei die Behandlung der Fläche der ersten Metallelektrode (110) eine Ablagerung mindestens eines benetzbaren Materials (136) auf der Fläche der ersten Metallelektrode (110) oder, wenn die erste Metallelektrode (110) mindestens ein erstes benetzbares Metallmaterial (114) aufweist, das von mindestens einem zweiten nichtbenetzbaren Material (116) bedeckt ist, eine Ätzung des zweiten nichtbenetzbaren Materials (116) aufweist, das auf der Fläche der ersten Metallelektrode (110) vorhanden ist.

5. Verfahren nach einem der vorangehenden Ansprüche, das ferner zwischen der Herstellung des optischen Trenngitters aus Metall (140) und der festen Verbindung des optischen Trenngitters aus Metall (140) die Ablagerung mindestens eines Lötmaterials (150) auf dem optischen Trenngitter aus Metall (140) aufweist.

6. Verfahren nach einem der vorangehenden Ansprüche, wobei das optische Trenngitter aus Metall (140) auf dem Träger (142) mit mindestens einer Opferschicht (144) hergestellt wird, die zwischen dem optischen Trenngitter aus Metall (140) und dem Träger (142) angeordnet ist und wobei die Entfernung des Trägers (142) durch Beseitigung der Opferschicht (144) durchgeführt wird.

7. Verfahren nach Anspruch 6, wobei:
- das Material der Opferschicht (144) imstande ist, gegenüber dem Material des optischen Trenngitters aus Metall (140) selektiv geätzt zu werden;
- das Verfahren ferner zwischen der Herstellung des optischen Trenngitters aus Metall (140) und der festen Verbindung des optischen Trenngitters aus Metall (140) eine Teilätzung der Opferschicht (144) derart aufweist, dass restliche Abschnitte der Opferschicht (144) zwischen dem optischen Trenngitter aus Metall (140) und dem Träger (142) lokalisiert sind;
- die Entfernung des Trägers (142) durch Beseitigung der restlichen Abschnitte der Opferschicht (144) durchgeführt wird.

8. Verfahren nach Anspruch 6, wobei:
- die Opferschicht (144) mindestens ein Material aufweist, das imstande ist, in einem Lösungsmittel gelöst zu werden und wobei die Entfernung des Trägers (142) mindestens ein Inkontaktversetzen der Opferschicht (144) mit dem Lösungsmittel aufweist, was eine Auflösung des Materials der Opferschicht (144) bewirkt, oder
- die Opferschicht (144) mindestens Polyimid aufweist und wobei die Entfernung des Trägers (142) mindestens ein Inkontaktversetzen der Opferschicht (144) mit einem Plasma aufweist, das ein Ätzen des Polyimids bewirkt.

9. Verfahren nach einem der Ansprüche 1 bis 5, wobei:
- das optische Trenngitter aus Metall (140) auf dem Träger (142) mit mindestens einer temporären Haftschicht (154) hergestellt wird, die zwischen dem optischen Trenngitter aus Metall (140) und dem Träger (142) angeordnet ist;
- die temporäre Haftschicht (154) mindestens ein Material aufweist, dessen Hafteigenschaften imstande sind, sich ab einer bestimmten Temperatur zu verschlechtern, der das Material ausgesetzt wird, und die feste Verbindung des optischen Trenngitters aus Metall (140) bei einer Temperatur über oder gleich der bestimmten Temperatur durchgeführt wird.

10. Verfahren nach einem der Ansprüche 1 bis 5, wobei:
- das optische Trenngitter aus Metall (140) auf dem Träger (142) mit mindestens einer temporären Haftschicht (154) hergestellt wird, die zwischen dem optischen Trenngitter aus Metall (140) und dem Träger (142) angeordnet ist;
- die temporäre Haftschicht (154) mindestens ein Material aufweist, dessen Hafteigenschaften imstande sind, sich zu verschlechtern, wenn das Material einer elektromagnetischen Strahlung ausgesetzt wird und die Entfernung des Trägers (142) mindestens eine Exposition der temporären Haftschicht (154) der elektromagnetischen Strahlung durch den Träger (142) hindurch aufweist.

11. Verfahren nach einem der Ansprüche 1 bis 5, wobei:
- das optische Trenngitter aus Metall (140) auf dem Träger (142) mit mindestens einer Oxidschicht (156) und mindestens einer Platinschicht (156) hergestellt wird, die zwischen dem optischen Trenngitter aus Metall (140) und dem Träger (142) angeordnet sind;
- die Entfernung des Trägers (142) mindestens eine mechanische Trennung an der Schnittstelle zwischen der Oxidschicht (156) und der Platinschicht (158) aufweist.

12. Verfahren nach einem der vorangehenden Ansprüche, wobei die Herstellung des optischen Trenngitters aus Metall (140) ferner die Herstellung mindestens eines Wellenlängeumwandlungselements (162) einer Strahlung auf dem Träger (142) aufweist, die bestimmt ist, von der lichtemittierenden und/oder lichtempfangenden Komponente (102) gesendet und/oder empfangen zu werden, das zwischen Abschnitten des optischen Trenngitters aus Metall (140) angeordnet ist, so dass das Wellenlängeumwandlungselement (162) nach der festen Verbindung des optischen Trenngitters aus Metall (140) dem Halbleiterstapel (104, 106, 108) der lichtemittierenden und/oder lichtempfangenden Komponente (102) zugewandt angeordnet ist.

13. Verfahren nach Anspruch 12, wobei das Wellenlängeumwandlungselement (162) Phosphor aufweist.

14. Verfahren nach einem der vorangehenden Ansprüche, wobei:
- mehrere lichtemittierende und/oder lichtempfangende Komponenten (102) hergestellt werden und eine Pixelmatrix der lichtemittierenden und/oder lichtempfangenden Vorrichtung (100) bilden;
- die erste Metallelektrode (110) um jede der lichtemittierenden und/oder lichtempfangenden Komponenten (102) angeordnet ist und den lichtemittierenden und/oder lichtempfangenden Komponenten (102) gemeinsam ist.

## Claims

1. Method for producing a photo-emitting and/or photo-receiving device (100) with a metal optical separation grid (140), comprising at least:
- producing at least one photo-emitting and/or photo-receiving component (102), wherein at least one first metal electrode (110) of the photo-emitting and/or photo-receiving component (102) covers lateral flanks of at least one semiconductor stack (104, 106, 108) of the photo-emitting and/or photo-receiving component (102) and extends to at least one emitting and/or receiving face (112) of the photo-emitting and/or photo-receiving component (102);
- treating at least one face of the first metal electrode (110) located at the emitting and/or receiving face (112), rendering wettable said face of the first metal electrode (110);
- producing of the metal optical separation grid (140) on at least one support (142);
- fastening of the metal optical separation grid (140) against said face of the first metal electrode (110) by brazing;
- removing the support (142).

2. Method according to claim 1, wherein the photo-emitting and/or photo-receiving component (102) includes at least one photo-emitting and/or photo-receiving diode comprising at least:
- first and second portions (104, 108) of doped semiconductors that are part of the semiconductor stack and which form a p-n junction, a first part (120) of the first portion (104) of doped semiconductor being disposed between a second part (122) of the first portion (104) of doped semiconductor and the second portion (108) of doped semiconductor;
- dielectric portions (118) that cover lateral flanks of the first part (120) of the first portion (104) of doped semiconductor and lateral flanks of the second portion (108) of doped semiconductor;
- a second electrode (124) electrically coupled to the second portion (108) of doped semiconductor and such that the second portion (108) of doped semiconductor is disposed between the second electrode (124) and the first portion (104) of doped semiconductor;
and wherein the first metal electrode (110) is disposed against outer lateral flanks of the dielectric portions (118) and against lateral flanks of the second part (122) of the first portion (104) of doped semiconductor such that the first metal electrode (110) is electrically coupled to the first portion (104) of doped semiconductor and electrically insulated from the second portion (108) of doped semiconductor.

3. Method according to one of the preceding claims, further including, between the production of the photo-emitting and/or photo-receiving component (102) and the treatment of the face of the first metal electrode (110), or after the removing of the support (142), an electrical and mechanical coupling of the photo-emitting and/or photo-receiving component (102), on the side opposite the emitting and/or receiving face (112), to at least one electronic control circuit (130).

4. Method according to one of the preceding claims, wherein the treatment of the face of the first metal electrode (110) includes a deposition of at least one wettable material (136) on the face of the first metal electrode (110), or, when the first metal electrode (110) includes at least one first wettable metal material (114) covered by at least one second non-wettable material (116), an etching of the second non-wettable material (116) present on the face of the first metal electrode (110).

5. Method according to one of the preceding claims, further including, between the producing of the metal optical separation grid (140) and the fastening of the metal optical separation grid (140), the deposition of at least one brazing material (150) on the metal optical separation grid (140).

6. Method according to one of the preceding claims, wherein the metal optical separation grid (140) is produced on the support (142) with at least one sacrificial layer (144) disposed between the metal optical separation grid (140) and the support (142), and wherein the removing of the support (142) is produced by suppressing the sacrificial layer (144).

7. Method according to claim 6, wherein:
- the material of the sacrificial layer (144) is able to be selectively etched with regards to the material of the metal optical separation grid (140);
- the method further includes, between the producing of the metal optical separation grid (140) and the fastening of the metal optical separation grid (140), a partial etching of the sacrificial layer (144) such that remaining portions of the sacrificial layer (144) are located between the metal optical separation grid (140) and the support (142);
- the removing of the support (142) is produced by suppressing the remaining portions of the sacrificial layer (144).

8. Method according to claim 6, wherein:
- the sacrificial layer (144) includes at least one material able to be dissolved in a solvent, and wherein the removing of the support (142) includes at least one putting of the sacrificial layer (144) into contact with the solvent generating a dissolution of the material of the sacrificial layer (144), or
- the sacrificial layer (144) includes at least polyimide, and wherein the removing of the support (142) includes at least one putting of the sacrificial layer (144) into contact with a plasma generating an etching of the polyimide.

9. Method according to one of claims 1 to 5, wherein:
- the metal optical separation grid (140) is produced on the support (142) with at least one temporary adhesive layer (154) disposed between the metal optical separation grid (140) and the support (142);
- the temporary adhesive layer (154) includes at least one material of which the adhesive properties are able to be degraded starting from a given temperature that said material is exposed to, and the fastening of the metal optical separation grid (140) is implemented at temperature greater than or equal to said given temperature.

10. Method according to one of claims 1 to 5, wherein:
- the metal optical separation grid (140) is produced on the support (142) with at least one temporary adhesive layer (154) disposed between the metal optical separation grid (140) and the support (142);
- the temporary adhesive layer (154) includes at least one material of which the adhesive properties are able to be degraded when said material is exposed to electromagnetic radiation, and the removing of the support (142) includes at least one exposure of the temporary adhesive layer (154) to the electromagnetic radiation through the support (142).

11. Method according to one of claims 1 to 5, wherein:
- the metal optical separation grid (140) is produced on the support (142) with at least one oxide layer (156) and at least one platinum layer (156) disposed between the metal optical separation grid (140) and the support (142);
- the removing of the support (142) includes at least one mechanical separation at the interface between the oxide layer (156) and the platinum layer (158).

12. Method according to one of the preceding claims, wherein the producing of the metal optical separation grid (140) further includes the producing, on the support (142), of at least one wavelength converting element (162) of a radiation intended for being emitted and/or received by the photo-emitting and/or photo-receiving component (102), disposed between portions of the metal optical separation grid (140) such that after the fastening of the metal optical separation grid (140), the wavelength converting element (162) is disposed facing the semiconductor stack (104, 106, 108) of the photo-emitting and/or photo-receiving component (102).

13. Method according to claim 12, wherein the wavelength converting element (162) includes phosphorus.

14. Method according to one of the preceding claims, wherein:
- several photo-emitting and/or photo-receiving components (102) are produced and form a pixel matrix of the photo-emitting and/or photo-receiving device (100);
- the first metal electrode (110) is disposed around each one of the photo-emitting and/or photo-receiving components (102) and is common to the photo-emitting and/or photo-receiving components (102).
